# EUROPÄISCHE PATENTSCHRIFT

(11) **EP 2 422 367 B1**
(45) Veröffentlichungstag und Bekanntmachung des Hinweises auf die Patenterteilung: **27.07.2016**
(21) Anmeldenummer: 10707875.0
(22) Anmeldetag: 26.02.2010
(51) Int. Cl.: H01L 23/31, H01L 23/495

(54) **GEKAPSELTE SCHALTUNGSVORRICHTUNG FÜR SUBSTRATE MIT ABSORPTIONSSCHICHT SOWIE VERFAHREN ZU HERSTELLUNG DERSELBEN**
ENCAPSULATED CIRCUIT DEVICE FOR SUBSTRATES WITH ABSORPTION LAYER AND METHOD FOR PRODUCING THE SAME
CIRCUIT ENCAPSULÉ POUR SUBSTRATS COMPORTANT UNE COUCHE D'ABSORPTION, ET PROCÉDÉ DE FABRICATION AFFÉRENT

(30) Priorität: 21.04.2009 DE 102009002519
(43) Veröffentlichungstag der Anmeldung: 29.02.2012
(73) Patentinhaber: Robert Bosch GmbH, 70442 Stuttgart (DE)
(72) Erfinder: NEUMEISTER, Jochen, 70469 Stuttgart (DE); RIEGER, Reinhard, 74336 Brackenheim (DE)
(86) Internationale Anmeldenummer: PCT/EP2010/052503
(87) Internationale Veröffentlichungsnummer: WO 2010/121860

(56) Entgegenhaltungen:
- EP-A2- 0 642 156
- JP-A- 2004 289 017
- US-A- 5 386 342
- US-A- 5 793 118
- US-A- 5 864 178
- US-A1- 2005 116 322
- US-A1- 2008 036 053

## Beschreibung

### Stand der Technik

Die Erfindung betrifft das Gebiet von substratbasierten Schaltungen und insbesondere Schaltungen mit mehreren diskreten oder integrierten Bauteilen, die auf dem Substrat vorgesehen sind.

Bei substratbasierten Schaltungen bzw. Schaltungen auf Leiterplattenbasis werden eine Vielzahl von einzelnen diskreten oder integrierten Bauelemente auf einem Substrat befestigt, das zum Einen die elektrische Verbindung zwischen den Bauelementen vorsieht und zum Anderen einen mechanischen Träger vorsieht. Als Träger wird eine Isolierschicht verwendet, die eine Leiterbahnschicht trägt, deren Struktur die elektrischen Verbindungen der elektrischen Bauteile definiert. Diese Schaltungstechnik unterscheidet sich prinzipiell von integrierten Schaltungen, bei denen ein einziger Siliziumchip sowohl Substrat als auch sämtliche Bauteile vorsieht und somit keine auf dem Substrat montierten Bauelemente vorgesehen sind.

Insbesondere bei Leistungsschaltungen, beispielsweise im Automobilbereich, ist die Schaltung für Hochstromanwendungen vorgesehen, wodurch sich hohe Belastungen hinsichtlich Verlustleistung, Stromstärke und Temperatur ergeben. Zudem erfordern zahlreiche Einsatzgebiete, dass die Schaltung gegenüber Umwelteinflüssen im Wesentlichen geschützt ist. Um eine höhere mechanische Stabilität zu erreichen und um den Temperaturbelastungen und der abzuführenden Verlustwärme Rechnung zu tragen, werden Keramiksubstrate verwendet, auf denen einzelne Bauelemente untergebracht sind.

Die Druckschrift DE 102006033175 A1 zeigt ein Elektronikmodul mit Leistungsteil und Logikteil, die zusammen in einem gemeinsamen Modulgehäuse eingebettet sind. Das Modulgehäuse wird somit durch die Masse vorgesehen, in die die Schaltungen eingebettet sind, wobei das Modulgehäuse den Schutz gegenüber äußeren Einflüssen ermöglicht und gleichzeitig Anschlüsse sowie Wärmeableitung vorsieht.

Die Druchschriften US 2005/0116322 A1 und US 5,864,178 zeigen ebenfalls gekapselle Elektronikmodule.

Da ein wie oben beschriebenes eingegossenes Schaltungsmodul zum Einen geschützt ist und zum Anderen Platz sparend mit einem Gehäuse versehen ist, betrifft die Erfindung ebenso eine gekapselte Struktur. Jedoch bietet die beschriebene Einkapselung durch Einbetten bzw. Eingießen auch Nachteile, da Materialien mit unterschiedlichen Eigenschaften, insbesondere mit unterschiedlichen Wärmeausdehnungskoeffizienten, aufeinander stoßen. Insbesondere dadurch, dass sich der Wärmeausdehnungskoeffizient des Substrats von dem des umgebenden Gehäusematerials unterscheidet, sondern auch die Bauelemente aus zahlreichen verschiedenen Materialien ausgebildet sind, ergeben sich Spannungen an der Grenzfläche zwischen Gehäusematerial und Bauelement bzw. zwischen Gehäusematerial und Substrat, wobei diese mechanischen Spannungen durch die von dem Gehäuse vorgesehenen mechanischen Verbindungen auch auf mechanische Spannungen zwischen Bauelementen übertragen wird. Die Folge sind unzuverlässige elektrische Kontakte, Unterbrechungen, durch mechanische Spannungen in ihrem Betrieb beeinflusste Bauelemente und Spaltbildung. Insbesondere bei Anwendungen, die über einen breiten Temperaturbereich gehen, oder die einen Temperaturbereich betreffen, der sich deutlich von dem Herstellungstemperaturbereich unterscheidet, ergeben sich derartige mechanische Spannungen.

Insbesondere im Automobilbereich werden jedoch derartige Schaltungen im Motorraum eingesetzt, wobei dort üblicherweise sehr starke Temperaturschwankungen auftreten. Gleichzeitig betreffen die Anwendungsgebiete auch für den Betrieb eines Kraftfahrzeugs zentrale Funktionen, so dass insbesondere im Automobilbereich trotz der starken Temperaturunterschiede eine besonders hohe Zuverlässigkeit vorgesehen werden muss. Ferner ergeben sich nicht nur zeitbezogene, sondern auch räumliche Temperaturunterschiede bei Hochleistungsanwendungen, insbesondere bei Hochleistungsmodulen für Elektroantriebe im Fahrzeugbereich, bei der Steuerung von Strömen, die den elektrischen Teil eines Hybridantriebs betreffen und auch bei Stromgeneratoren oder auch Lichtmaschinen von Kraftfahrzeugen. Es ist unmittelbar aus diesen Anwendungsbereichen ersichtlich, dass die Schaltung durch ein Gehäuse geschützt werden muss, wobei die mit dem Gehäuse versehene Schaltungsstruktur besonders Platz sparend vorgesehen werden sollte.

Es ist daher eine Aufgabe der Erfindung, eine Schaltungsvorrichtung sowie ein Verfahren zu deren Herstellung vorzusehen, das für die oben genannten Einsatzbereiche geeignet ist und insbesondere für breite Temperaturbereiche geeignet ist.

### Offenbarung der Erfindung

Die Erfindung ermöglicht eine besonders Platz sparende Schaltungsstruktur, die gut gegen äußere Einflüsse geschützt ist und die auch bei besonders starken Temperaturunterschieden zuverlässig arbeitet. Insbesondere ermöglicht die erfindungsgemäße Schaltungsstruktur, dass mechanische Spannungen, welche zahlreiche Probleme insbesondere bei breiten Temperatureinsatzbereichen erzeugen, um Größenordnungen reduziert sind, wobei die Mittel zu der Reduktion der mechanischen Spannungen nur mit einem sehr geringen oder mit keinem zusätzlichen Platzbedarf verknüpft sind. Insbesondere eignet sich die Schaltung für Substrate und Bauelemente mit großen Abmessungen, insbesondere für Substrate mit einer Dicke, die deutlich größer als die Dicke eines Siliziumchips ist, ohne dass sich durch das große eingeschlossene Volumen bei starken Temperaturveränderungen wesentliche mechanische Spannungen ergeben würden. Ferner ist die Erfindung dafür geeignet, auch bei starken räumlichen Temperaturgradienten innerhalb der Schaltung, wie sie vor allem bei größeren Schaltungen aufgrund der Wärmeakkumulierung auftreten, um ein Vielfaches zu verringern. So ermöglicht die Erfindung beispielsweise auch die Anordnung eines stark Wärme erzeugenden Bauteils auf dem gleichen Substrat wie ein Bauteil, das eine deutlich geringere Temperatur aufweist, ohne dass sich Spalte oder mechanische Spannungen ergeben würden.

Die erfindungsgemäße Lösung sieht vor, ein Substrat inklusive der darauf montierten Bauelemente mit einer starren äußeren Kapselung zu versehen, um eine hohe mechanische Stabilität zu ermöglichen, und gleichzeitig die starre äußere Kapselung mechanisch von dem Substrat und von den Bauelementen durch eine zusätzliche Absorptionsschicht zu trennen. Die Absorptionsschicht dient zur Absorption von entstehenden Spannungen, die sich insbesondere bei Temperaturveränderungen durch die Relativbewegung zwischen Komponenten der Schaltungsvorrichtung mit unterschiedlichen Wärmeausdehnungskoeffizienten ergeben. Die Absorptionsschicht ist als komprimierbare Absorptionsschicht vorgesehen, so dass thermisch bedingte Bewegungen der Substratoberfläche bzw. der Bauelemente relativ zu der äußeren Kapselung durch Verformung der Absorptionsschicht aufgenommen wird, ohne dass diese einen wesentlichen Druck auf Teile der Schaltungsvorrichtung ausübt, der den Betrieb der Schaltungsvorrichtung beeinträchtigen könnte. Die Absorptionsschicht ist gleichzeitig ein Platzhalter, um zu vermeiden, dass die starre äußere Kapselung bei deren Anordnung in direktem Kontakt zu spannungsempfindlichen Teilen der Schaltungsvorrichtung gerät. Die Verformung der Absorptionsschicht kann eine elastische Verformung mit einer Federkonstanten oder mit einem Elastizitätsmodul sein, das deutlich unter dem der starren äußeren Kapselung liegt. Zudem kann die Verformung der Absorptionsschicht plastisch sein, wobei zur Volumenänderung im Vergleich zur starren äußeren Kapselung nur geringe Spannungen notwendig sind, oder kann eine Kombination von elastischem und plastischem Verformen sein. Die Absorptionsschicht nimmt einen Großteil der Verformungen auf, die den Volumenänderung entsprechen, wobei als Großteil zumindest 90 % der Volumenänderung bezeichnet werden.

Während die starre äußere Kapselung eine geringe mechanische Flexibilität hat, die sich anhand des Elastizitätsmoduls, des Kompressionsmoduls, des Schubmoduls, der Poissonzahl oder einer Kombination hiervon ermessen lässt, sieht die Absorptionsschicht eine deutlich höhere Verformbarkeit vor, so dass bereits bei geringeren mechanischen Spannungen in der Absorptionsschicht deutlich mehr Relativvolumen bewegt wird als in der starren äußeren Kapselung. Insbesondere ist die Absorptionsschicht deutlich mechanisch flexibler als das Substrat und als die verwendeten Bauelemente vorgesehen. In einem zahlenbezogenen Vergleich ist das Elastizitätsmodul der komprimierbaren Absorptionsschicht weniger als 10 % des Elastizitätsmoduls der starren äußeren Kapselung, insbesondere bei weichen Absorptionsschichten weniger 1/100, 1/500, 1/1000, oder 1/10000 des Elastizitätsmoduls der starren äußeren Kapselung. Während die starre äußere Kapselung eine Festigkeit eines zur Kapselung von Schaltungen üblichen Hartkunststoffs bzw. Molding- oder Spritzgussmaterials aufweist, ist die Absorptionsschicht beispielsweise mit einer Festigkeit ausgestattet, die Silikon oder ein Silikongel typischerweise aufweist. Die anhand des Elastizitätsmoduls getroffenen Vergleiche gelten auch für das Kompressionsmodul. Die hier genannten Vergleiche der Komprimierbarkeit bzw. der Elastizität zwischen Absorptionsschicht und äußerer Kapselung gilt ebenso für einen Vergleich der Komprimierbarkeit bzw. der Elastizität zwischen der Absorptionsschicht und den Bauelementen, bzw. zwischen der Absorptionsschicht und dem Substrat. Somit wird vorzugsweise eine Absorptionsschicht mit einem Elastizitätsmodul verwendet, das weniger als 10 % des Elastizitätsmoduls des Substrats beträgt, vorzugsweise weniger als 1/100 des Elastizitätsmoduls des Substrats. (In einigen erfindungsgemäßen Ausführungen kann das Elastizitätsmodul der Absorptionsschicht weniger als 1/500, 1/1000, 1/5000 oder 1/10000 des Elastizitätsmoduls des Substrats betragen). Gleiches gilt auch für einen Vergleich der mechanischen Eigenschaften der Absorptionsschicht mit den mechanischen Eigenschaften der verwendeten Bauelemente. Damit ist gewährleistet, dass die Absorptionsschicht deutlich komprimierbarer als alle anderen Elemente der Schaltungsvorrichtung ist, so dass bei auftretenden Relativbewegungen, die aus Temperaturunterschieden resultieren, im Wesentlichen nur die Absorptionsschicht die sich ergebende mechanische Kompression oder Dehnung aufnimmt. In diesem Kontext bedeutet im Wesentlichen, dass die Absorptionsschicht mindestens 95 %der Volumenveränderung aufnimmt, die aus der Bewegung der äußeren Kapselung bzw. deren Innenfläche relativ zu dem Substrat und relativ zu den Bauelementen aufnimmt. (In einigen Fällen kann die Absorptionsschicht eingerichtet sein, um mindestens 99 % oder auch in anderen Fällen mindestens 90 % der Volumenveränderung aufzunehmen).

Bei der Herstellung der erfindungsgemäßen Schaltungsvorrichtung werden somit vor dem Aufbringen der äußeren Kapselung zumindest Teile des Substrats und die Bauelemente mit der Absorptionsschicht überzogen, so dass bei dem darauf folgenden Aufbringen der äußeren Kapselung gewährleistet ist, dass diese nicht in unmittelbarem Kontakt zu dem Substrat oder den Bauelementen steht, sondern zwischen Kapselung und Substrat bzw. Bauelementen immer eine Mindestschichtdicke der Absorptionsschicht gewährleistet ist. Die Mindestschichtdicke hängt von dem zu erwartenden Temperaturbereich, den unterschiedlichen Wärmeausdehnungskoeffizienten und von den Abmessungen ab, weist jedoch eine Mindestdicke von mindestens 50 µm auf. Insbesondere wird eine Absorptionsschicht in der Vorrichtung vorgesehen bzw. im Verfahren aufgetragen, die eine Mindestdicke von 200 µm, 500 µm, 1 mm, 1,5 mm, 2 mm, 2,5 mm oder 3 mm hat. Dies kann die gesamte Absorptionsschicht betreffen oder auch nur Abschnitte hiervon. Die Dicke kann ferner für die gesamte Absorptionsschicht oder nur stellenweise bis zu 3 mm betragen. Diese Obergrenze gewährleistet eine noch akzeptable Wärmeabfuhr. Um den zusätzlichen Platzbedarf zu minimieren und um die Wärmeableitungsfähigkeiten der Kapselung nicht unnötig zu verschlechtern, weist die Absorptionsschicht eine maximale Dicke von 5 mm auf. Ferner kann die Absorptionsschicht mit einer maximalen Dicke von 4 mm oder 3 mm vorgesehen sein. Bevorzugt ist eine Dicke von ungefähr 3 mm, von 2 mm oder von 1 mm für die gesamte Absorptionsschicht oder nur für Teile hiervon. Jedoch besonders bevorzugt ist eine derartige Dicke zwischen ca. 1 mm bis 2 mm. Dies wird gemessen zwischen Positionen der äußeren Kapselung und einem gegenüberliegenden Bauelement bzw. einer gegenüberliegenden Substratposition.

Die erfindungsgemäße Schaltungsvorrichtung umfasst ferner vorzugsweise einen elektrischen Kontakt bzw. Kontaktierung, der bzw. die durch die äußere Kapselung und gegebenenfalls auch durch Teile der Absorptionsschicht hindurch verläuft, und der einen äußeren Abschnitt umfasst, der aus der Kapselung herausragt. Mit dem herausragenden Außenabschnitt lassen sich externe elektrische Anschlüsse realisieren. Somit erstreckt sich der zumindest eine elektrische Kontakt (bzw. die zumindest eine Kontaktierung) ausgehend von dem Substrat durch die gesamte Kapselung, wobei die Kapselung, zumindest die starre äußere Kapselung, die Schaltungsvorrichtung (bis auf den Außenabschnitt des Kontakts) vollständig umgibt. Der elektrische Kontakt kann eine Kontaktleiste aus Draht- oder Blechstreifen umfassen, die direkt mit dem Substrat oder über eine Bondingverbindung mit diesem elektrisch verbunden sind. Die starre äußere Kapselung bietet eine mechanische Fixierung für den elektrischen Kontakt.

Die Absorptionsschicht deckt vorzugsweise die gesamte Substratoberfläche der Bauelementseite ab, wobei die Bauelementseite des Substrats die Seite ist, auf der die Bauelemente montiert sind. Ferner kann die Absorptionsschicht zwar die gesamten Bauelemente und die dort vorliegende Substratoberfläche (auch zwischen den Bauelementen) abdecken, wobei ein äußerer Rand der Substratoberfläche verbleibt, an dem beispielsweise der elektrische Kontakt oder die Kontaktleiste vorgesehen ist. Alternativ kann sich die Absorptionsschicht auch über die Verbindungen zwischen elektrischem Kontakt und Substrat erstrecken. Die Absorptionsschicht kann sich ferner über die gesamte Unterseite des Substrats erstrecken. Umfasst die Schaltungsvorrichtung jedoch einen an der Unterseite angebrachten Kühlkörper, so ist dieser (unter anderem aus thermischen Gründen) von der Absorptionsschicht ausgenommen, wobei die Absorptionsschicht auch die Seitenflächen des Substrats überdecken kann. Zur zusätzlichen elektrischen Isolierung, insbesondere bei hohen Isolationsanforderungen und bei nicht vollständig isolierendem Verhalten der Absorptionsschicht kann zwischen dem Substrat / den Bauelementen und der Absorptionsschicht eine flexible Isolationsschicht vorgesehen sein, die gegenüber diesen die Absorptionsschicht elektrisch isoliert. Neben einem flächigen Kühlkörper in Form einer Platte, der an der Unterseite des Substrats unmittelbar an dem Substrat angebracht ist, und der von der Absorptionsschicht ausgenommen ist, kann die Schaltungsvorrichtung auch eine Kappe umfassen, die auf der Bauelementseite des Substrats angeordnet ist. Die Kappe sieht eine ebene Oberfläche vor, die von dem Substrat weg weist, so dass das Aufbringen des Materials, das die spätere starre äußere Kapselung bildet, vereinfacht wird, insbesondere bei Hartkunststoffmaterial bzw. Moldingmaterial, das beim Aufbringen viskos ist. Das Aufbringen des Materials, das die starre Kapselung bildet (=Moldingmaterial), d.h. das Aufbringen einer Außenkapselungsschicht, wird durch einen Fließprozess ausgeführt, bei dem das Moldungmaterial, welches die äußere Kapselung bildet, gegossen wird im Rahmen eines Molding-Prozesses. Hierbei wird fließfähiges Moldungmaterial in Form von Moldmasse (bsp. ein Duroplast) aufgebracht, vorzugsweise unter Druck. Die Kappe schützt ferner das Substrat und die Bauteile vor äußeren Beeinträchtigungen wie Verformung während dem Aufbringen der (gegossenen) Außenkapselungsschicht durch diesen Moldingprozess. Die Kappe schützt ferner Bondingverbindungen während dem Aufbringen der (gegossenen) Außenkapselungsschicht vor Verformung. Bondingverbindungen sind somit vorzugsweise unter der Kappe angeordnet. Die verfestigte Moldingschicht liegt unmittelbar an einer ebenen Fläche der Kappe an, wodurch Wärmeleitfähigkeit gewährleistet bleibt und ausgeschlossen wird, dass die Wärmeabfuhr vom Substrat / von den Bauelementen nach außen durch unerwünschte Einschlüsse gestört ist. Die Kappe kann als zusätzlichen Schutz vor äußerer mechanischer Einwirkung dienen, sowie auch als Kühlelement, mit dem sich die entstehende Wärme abgeführt werden kann. Die Kappe ist vorzugsweise so ausgeformt, dass sie das höchste Bauelement (in montierter Form) umgreifen kann, ohne dieses zu berühren, vorzugsweise mit einem Sicherheitsabstand von ca. 1 mm oder weniger. Die Kappe kann alle Bauelemente oder nur einen Teil hiervon, insbesondere nur die Leistungsbauteile, oder eine Leistungsgruppe der Bauelemente abdecken und umschließt die betreffenden Bauelemente zusammen mit der Substratoberfläche der Bauelementseite vollständig. Die Kappe sieht somit einen Raum für die darin befindlichen Bauelemente vor, der zur vollständigen Aufnahme der Bauelemente ausgebildet ist. Erfindungsgemäß umgreift die Kappe nicht nur die betreffenden Bauelemente, sondern auch die Absorptionsschicht, die auf dem Substratabschnitt und auf den Bauelementen aufgebracht ist, die in der Kühlkörperkappe vorgesehen sind. Die Absorptionsschicht erstreckt sich zumindest teilweise oder vollständig ausgehend von dem Bauelement oder dem Substrat bis zur Kappe, um so einen durchgehenden körperlichen Kontakt herzustellen. Dieser dient dann insbesondere der Wärmeableitung. Zwischen Kappe und Absorptionsschicht bzw. zwischen Absorptionsschicht und Bauelement kann ferner ein Hohlraum in Form eines Schlitzes vorgesehen sein. Vorzugsweise ist jedoch kein Schlitz zwischen Absorptionsschicht und Kappe vorgesehen. Dies wird erreicht, indem die Kappe mit einer oder mit mehreren Öffnungen vorgesehen wird, um beim Einfüllen des Materials der Absorptionsschicht eine vollständige Füllung zu erreichen, so das kein Schlitz entsteht. Die Öffnungen dienen zum Druckausgleich und Volumenausgleich beim Einfüllen des Absorptionsschichtmaterials, so dass keine Luftblasen verbleiben, sondern beim Einfüllen das gesamte Gas, das sich in der Kappe befunden hat, entfernt wird, und das Absorptionsschichtmaterial den Raum vollständig einnimmt. Ein Druckausgleich oder Volumenausgleich kann aber auch durch gezielte Luftblasen im Absorptionsmaterial oder auch durch eine Restmenge Luft in der Kappe erfolgen. Die Restmenge Luft bzw. die Luftblasen sind vorzugsweise weniger oder nicht über Leistungsbauteilen oder anderen Wärme erzeugenden Bauteilen angeordnet sondern über Bauteilen, die nur geringfügig oder keine Wärme erzeugen, d.h. an einer thermisch unkritischen Stelle, um die Wärmeabfuhr durch die Luft nicht zu behindern.

Sowohl Kappe als auch Kühlkörper, der an der Unterseite angebracht ist, sind vorzugsweise aus Metall, insbesondere mit einer Blechdicke von größer als 0,1 mm und insbesondere größer als 0,3 mm, um eine geeignete Wärmeableitung und mechanischen Schutz vor extern beaufschlagten mechanischen Spannungen zu ermöglichen. Die Blechdicke ist vorzugsweise geringer als 1 mm oder geringer als 0,5 mm. Gemäß einer Ausführungsform der Erfindung ist die Kappe vollständig mit der äußeren Kapselung umgeben, wobei die Kappe alternativ auch an einem Außenabschnitt der Kappe von der äußeren Kapselung ausgenommen sein kann. Bei einem Wärme erzeugenden Bauteil kann somit die Wärme über die Absorptionsschicht direkt an die Kühlkörperkappe nach außen abgeben werden oder kann über das Substrat und über den Kühlkörper unmittelbar nach außen abgeben werden.

Das Material der Absorptionsschicht weist vorzugsweise eine hohe Wärmeleitfähigkeit auf, beispielsweise eine Wärmeleitfähigkeit, die typischerweise Silikon aufweist, um das Entstehen einer Wärmeinsel unterhalb der Absorptionsschicht zu vermeiden. Vorzugsweise ist die Absorptionsschicht aus Silikonmaterial, aus Kautschuk, aus Silikongel oder aus einem anderen elektrisch isolierenden Gel vorgesehen. Im Allgemeinen umfasst die Absorptionsschicht isolierendes Material, um weder für das Substrat noch für die darauf angeordneten Bauelemente einen unerwünschten elektrischen Kontakt vorzusehen. Die Absorptionsschicht an der Bauteilseite (Oberseite) des Substrats kann aus einem anderen Material sein als die entgegengesetzte Absorptionsschicht (Unterseite). Ist beispielsweise an der Unterseite ein Kühlkörper oder eine Kühlplatte angeordnet, so ist das Material der Absorptionsschicht an der Unterseite vor allem Wärme leitend und gegebenenfalls im Vergleich zum Unterseitenmaterial schlechter elektrisch isolierend, während das Material der Absorptionsschicht auf der Oberseite insbesondere elektrisch isolierende Eigenschaften aufweist und im Vergleich eine geringere Wärmeleitfähigkeit hat. Beispielsweise kann die Absorptionsschicht auf der Unterseite des Substrats, das einen Kühlkörper aufweist, auch durch Wärmeleitkleber vorgesehen sein, mit dem der Kühlkörper am Substrat befestigt ist.

Das erfindungsgemäße Verfahren zur Herstellung umfasst daher das Bestücken eines Substratoberflächenabschnitts einer Bauelementseite mit diskreten und integrierten Bauelementen, das Anbringen des elektrischen Kontakts an das Substrat, sowie das darauf folgende erfindungsgemäße Kapseln der sich so ergebenden Schaltung. Das Umschließen umfasst zunächst das Aufbringen der Absorptionsschicht, worauf gegebenenfalls das Aufbringen der Kappe erfolgt. Nach dem Aufbringen der Absorptionsschicht an den oben beschriebenen Stellen und gegebenenfalls nach dem Anordnen der Kappe wird die starre äußere Kapselung an den oben beschriebenen Orten aufgebracht. Ein Außenabschnitt der elektrischen Kontakte wird von der gesamten Kapselung aus gespart. So auch gegebenenfalls ein entsprechender Außenabschnitt der Kappe oder des Kühlkörpers. Zur Durchführung des Verfahrens werden die Materialien und Komponenten der oben beschriebenen Schaltungsvorrichtung verwendet. Das Aufbringen der Absorptionsschicht umfasst beispielsweise das Eintauchen des Substrats in ein Absorptionsschichtmaterial. Alternativ zum Eintauchen kann das Absorptionsschichtmaterial auch aufgesprüht oder aufgegossen werden, oder auch (insbesondere auf die Unterseite, d.h. der von den Bauelemente abgewandte Seite) gedruckt oder gestempelt werden. Insbesondere wird die Absorptionsschicht aufgebracht durch Eintauchen des bestückten Substrats in eine sich verfestigende Flüssigkeit, beispielsweise in flüssiges Silikon, wobei das Eintauchen vollständig oder unvollständig vorgesehen werden kann, je nach erwünschter Erstreckung der Absorptionsschicht. Im Falle von aufgebrachtem flüssigem Silikon wird dieses vernetzt durch die üblichen Härtungsschritte bzw. Verfestigungsdauer.

Anstatt Silikon kann prinzipiell auch ein weicher Kunststoff verwendet werden, der z.B. mittels Spritzguss aufgebracht wird. In einer weiteren Ausführungsform wird als Absorptionsschichtmaterial Kunstharz verwendet, das gemäß üblicher Techniken (UV-Härten oder Erwärmen) verfestigt wird. Eine weitere Ausführungsform umfasst ein weiches Kunststoffmaterial, Kunstharz oder insbesondere eine Mischung hiervon. Die Ausbildung der Absorptionsschicht umfasst somit das Verfestigen der Absorptionsschicht nach dem Aufbringen, falls dies erforderlich ist, wobei insbesondere im Fall von Gelmaterialien gemäß den mechanischen Eigenschaften von Gel keine vollständige Verhärtung durchgeführt wird. Vielmehr wird die Absorptionsschicht dargestellt, indem nach dem Verfestigen die erwünschten mechanischen Eigenschaften der Absorptionsschicht vorgesehen werden. Die äußere Kapselung kann ebenso in weichem Zustand, beispielsweise durch Spritzen, auf die Absorptionsschicht aufgebracht werden, wobei sich die äußere Kapselung beispielsweise durch Erkalten, durch Vernetzung oder auf andere Weise verhärtet. Während des Spritzens ist das Material durch vorherige Erwärmung verflüssigt, das Material ist während des Spritzens daher in heißem (verflüssigtem) Zustand.. Als Material für die äußere Kapselung d.h. für die Moldmasse sind Hartkunststoffmaterialien oder eine Mischung von zunächst fliessfähigen und härtbaren Hartkunststoffmaterialien und Feststoffpartikeln geeignet.

Die verwendete Absorptionsschicht der Schaltungsvorrichtung bzw. die vom Verfahren vorgesehene Absorptionsschicht ist somit vorzugsweise eine verformbare Schicht, wohingegen die äußere Verkapselung eine harte, prinzipiell elastische und wenig dehnbare Außenschicht bildet. Die äußere Verkapselung ist somit ein harter Werkstoff, der von außen einwirkende mechanische Belastungen aufnimmt und das Bauteilinnere durch mechanische Stabilität von äußeren mechanischen Einwirkungen schützt. Gleichzeitig ist die äußere Verkapselung mechanisch stabil, nicht spröde und nimmt Kräfte elastisch auf, wenn auch mit einem für Hartmaterialen typischen hohen Elastizitätsmodul, beispielsweise größer als 10 kN/mm². Beide Schichten weisen vorzugsweise eine hohe Wärmeleitfähigkeit auf. Das Herstellungsverfahren zielt darauf ab, dass die Morphologie der beiden Schichten einer nicht porösen Struktur entspricht. Die Schichten werden mittels durchgehendem Vollmaterial vorgesehen, das herstellungsbedingt einzelne Blasen aufweisen kann, wobei eine gute Wärmeüberleitung und eine stabile mechanische Struktur gewährleistet wird. Die Schichtdicke der Absorptionsschicht kann konstant sein oder kann mit einer wie oben beschriebenen vorgesehenen Mindestdicke vorgesehen sein. Insbesondere die Dicke der Absorptionsschicht zwischen Leistungsbauelementen und äußerer Kapselung entspricht vorzugsweise einem Minimum aller Dicken der Schicht, um eine gute Wärmeübertragung zu ermöglichen. Gleichzeitig ist dort vorzugsweise eine Dicke gegeben, die mindestens der Mindestdicke entspricht. Als Substrat werden insbesondere Keramiksubstrate verwendet, oder auch Leiterplatten bzw. gedruckte Leiterplatten mit einer oder einer Vielzahl von Leiterbahnebenen. Das Substrat kann aus einem Verbundwerkstoff bestehen, beispielsweise einem Keramikverbundwerkstoff, oder auch Papier bzw. Hartpapiersubstrate oder Glasvlies bzw. Glasfasersubstrate, die mit einem Harzmaterial oder Kunststoff getränkt bzw. durchsetzt sind, bsp. Phenol (insbesondere als Kombination mit Hartpapier) oder Epoxy (insbesondere Di-/Tetra-Epoxy), Polyimid, oder Teflon. Als Substrat können auch Verbundwerkstoffe mit Keramik oder Keramikwerkstoffe verwendet werden. Das Substrat weist mindestens eine Metallschicht auf, vorzugsweise aus Kupfer oder Silber, die zur elektrischen Verbindung der Bauelemente dient. Das Substrat kann ferner eine Wärmeleitplatte, vorzugsweise aus Kupfer, auf der Seite umfassen, die dem Bauelement entgegengesetzt ist, wobei diese Metallplatte als Kühlkörper dient. Als Keramiksubstrat eignen sich LTCC-Keramiken, HTCC-Keramiken, beispielsweise mit gedruckten Schaltungen, oder auch in Dickschicht- oder Dünnschichttechnik hergestellte Keramiksubstrate, Hybrid-Keramiksubstrate oder Standard-Keramiksubstrate, beispielsweise mit Aluminiumoxid. Das Substrat kann gesintert sein oder als durchgängige Schicht vorgesehen sein, und kann ferner gedruckte Schaltungen tragen, sowie eine oder mehrere strukturierte Leiterbahnschichten.

Die Bauelemente umfassen vorzugsweise Hochstrombauelemente, die passiv oder aktiv sein können. Aktive Bauelemente umfassen Dioden, Transistoren, Thyristoren, Triacs oder integrierte Schaltungen, und die passiven Bauelemente umfassen Widerstände, Spulen, Kondensatoren. Einige oder alle der Bauelemente können als Hochleistungsbauelemente ausgebildet sein, insbesondere die aktiven Bauelemente sowie Spulen oder Widerstände, die als Shunt-Widerstand geschaltet sind. Als Leistungsbauelemente ausgelegte Bauelemente umfassen mindestens eine Wärmeabgabefläche, die zu dem Substrat hin oder von dem Substrat weg gewandt ist, sowie gegebenenfalls einen Kühlkörper, der direkt auf dem Bauelement montiert ist, um die Wärme in die Absorptionsschicht abzugeben. Neben leistungsintensiven Bauelementen können auch für geringere Leistungen ausgelegte Bauelemente verwendet werden, beispielsweise passive Bauelemente oder integrierte Schaltungen für Datenverarbeitungsaufgaben, Signalverarbeitungsaufgaben oder Logikbausteine. Grundsätzlich können die Bauelemente unverpackte Bauelemente sein oder Bauelemente, die ein eigenes Gehäuse mit Kontakten aufweisen können, insbesondere ICs oder aktive/passive Bauelemente mit geringerer Komplexität, bsp. Leistungshalbleiter oder vorgefertigte passive Bauelemente wie Induktivitäten, Widerständen oder Kondensatoren mit Gehäuse (bsp. als eingegossene Bauelemente).

Sämtliche Substrate, die hier als Keramiksubstrate aufgeführt sind, können auch als Faserverbundsubstrat ausgeführt sein wie Hartpapierleiterplatten oder Epoxy-Leiterplatten oder andere Faser/Kunststoff-Verbundplatten.

Die erfindungsgemäße Schaltungsvorrichtung kann eine Vielzahl von Kontakten zur Durchsteck- oder SMD-Montage aufweisen. Die Kontakte sind vorzugsweise in mindestens einer Reihe ausgebildet, beispielsweise als paarige Reihen, die sich gegenüberstehen, wobei die Schaltungsvorrichtung insbesondere ein oder zwei Paare dieser Kontaktleisten aufweisen kann. Die Gesamtanzahl der Kontakte kann 2 bis 80 oder mehr betragen, je nach Einsatz und Funktion. Die Schaltungsvorrichtung kann deutlich größer als übliche IC-Gehäuse sein, beispielsweise mit Kantenlängen von > 10 mm, > 35 mm, oder > 55 mm; beispielsweise kann die Schaltungsvorrichtung eine Größe von 35 mm x 55 mm haben.

### Kurze Beschreibung der Zeichnungen

Ausführungsbeispiele der Erfindung sind in den Zeichnungen dargestellt und in der nachfolgenden Beschreibung näher erläutert.

Es zeigen
Figur 1 eine Erstausführungsform der erfindungsgemäßen Schaltungsvorrichtung;
Figur 2 eine zweite Ausführungsform der erfindungsgemäßen Schaltungsvorrichtung;
Figur 3 eine dritte Ausführungsform der erfindungsgemäßen Schaltungsvorrichtung;
Figur 4 eine vierte Ausführungsform der erfindungsgemäßen Schaltungsvorrichtung;
   und
Figur 5 eine fünfte Ausführungsform der erfindungsgemäßen Schaltungsvorrichtung.

### Ausführungsformen der Erfindung

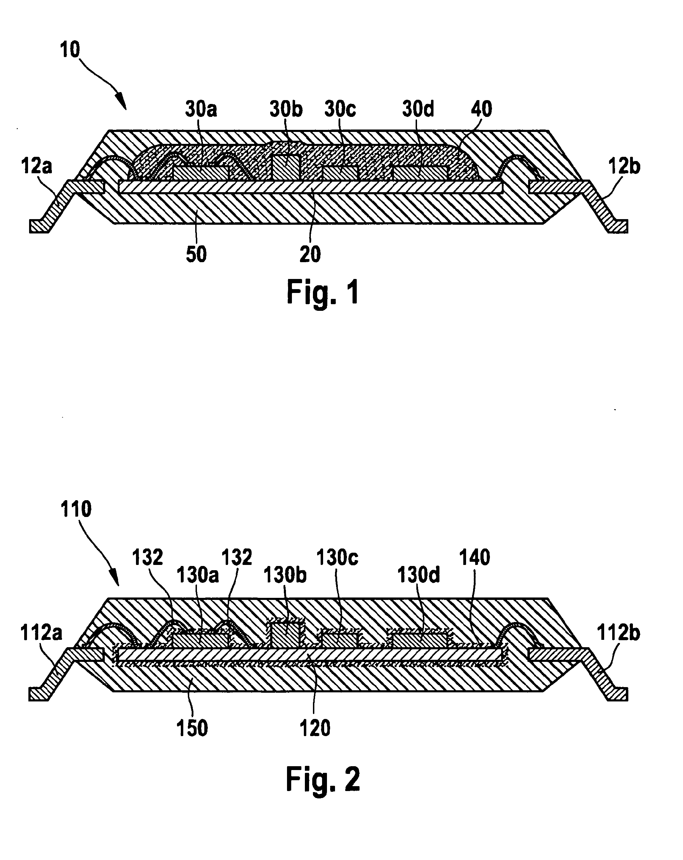

In der Figur 1 ist eine erfindungsgemäße Schaltungsvorrichtung 10 dargestellt, die elektrische Kontakte 12a, b umfasst. Die Schaltungsvorrichtung 10 umfasst ein Substrat 20, auf dem Bauelement 30a-d vorgesehen sind. Die Bauelemente 30a-d sind beispielsweise mittels SMD-Löttechnik oder mittels elektrisch leitfähiger Klebung auf der Bauelementseite des Substrats 20 angeordnet, die eine strukturierte Leiterschicht trägt. Alle Bauelemente 30a-d sind von einer komprimierbaren Absorptionsschicht 40 umgeben, die die Bauelemente sowie einen Substratoberflächenabschnitt der Bauelementseite des Substrats vollständig abdeckt. Auf der einen Seite deckt die Absorptionsschicht eine Verbindung zum elektrischen Kontakt 12a (d.h. eine Bondingverbindung an dem Substrat) ab, wohingegen die auf dem Substrat vorgesehene Verbindung zu dem Kontakt 12b nicht von der Absorptionsschicht abgedeckt wird. Die Absorptionsschicht deckt nicht die vollständige Bauelementseite des Substrats 20 ab, sondern es verbleibt ein Rand zwischen dem abgedeckten Substratoberflächenabschnitt und der vollständigen Bauelementseite, an der der elektrische Kontakt 12b (nicht aber der elektrische Kontakt 12a) mit dem Substrat verbunden ist. Eine äußere Kapselung 50 überdeckt die gesamte Schaltung sowie die gesamte komprimierbare Absorptionsschicht, wobei Innenabschnitte der elektrischen Kontakte 12a und b innerhalb der äußeren Kapselung 50 vorgesehen sind, um eine Verbindung zu dem Substrat zu ermöglichen (in Figur 1 eine Bondingverbindung), wohingegen die elektrischen Kontakte ferner Außenabschnitte umfassen, die aus der äußeren Kapselung und somit aus der gesamten Kapselung herausragen. Die elektrischen Kontakte 12a und b sind als Pins oder als Blechstreifen ausgebildet, die zur weiteren Verbindung mit externen Schaltungen, beispielsweise mittels einer Lötverbindung, angeschlossen werden können.

Die Figur 2 zeigt eine zweite Ausführungsform der erfindungsgemäßen Schaltungsvorrichtung 110, die ein mit Bauelementen 130a-d bestücktes Substrat 120 umfasst. Die Bauelemente sind über Lötverbindungen und auch über Bondingverbindungen 132 mit dem Substrat bzw. mit einer Leiterschicht des Substrats verbunden. Elektrische Kontakte 112a,b stellen den externen Kontakt zu dem eingekapselten, bestückten Substrat 120 her. Ebenso wie auch die erste, in Figur 1 dargestellte Ausführungsform, umfasst die Schaltungsvorrichtung 110 der Figur 2 eine äußere Kapselung 150, sowie eine Absorptionsschicht, deren Lage 140 symbolhaft mit einer gepunkteten Linie dargestellt ist. Es ist aus Figur 2 zu erkennen, dass die Absorptionsschicht 140 das bestückte Substrat (d.h. auch alle Bauelemente) vollständig umgreift. Im Gegensatz zu der Ausführungsform in Figur 1, in der die äußere Kapselung direkten Kontakt mit der Substratunterseite, den Seitenflächen des Substrats sowie einem äußeren Rand des Substrats auf der Bauelementseite hat, besteht zwischen äußerer Kapselung und Substrat bzw. Bauelementen immer ein Mindestabstand, der der Dicke der Absorptionsschicht entspricht. Da die Absorptionsschicht in Figur 2 das gesamte Substrat umgreift, schließt das Substrat auch Verbindungen mit den elektrischen Kontakten 112a,b ein, wobei die Verbindungen als Bondingpunkte auf dem Substrat vorgesehen sind. In diesem Fall durchstößt eine Verbindung, die das Substrat mit den elektrischen Kontakten verbindet (eine Bondingverbindung), die Absorptionsschicht vollständig. Gegebenenfalls weitere vorliegenden elektrischen Kontakte der Vorrichtung sind in der Figur 1 nicht dargestellt. Die mit Punkten dargestellte Linie zeigt lediglich die Lage der Absorptionsschicht, jedoch nicht deren Ausdehnung. Die Absorptionsschicht weist, wie auch in der Figur 1, eine Mindestdicke auf, die eine Mindestdistanz zwischen Bauteiloberfläche bzw. Substratoberfläche und äußerer Kapselung definiert. Diese Distanz entspricht der oben beschriebenen Dicke der Absorptionsschicht, die gemäß einer Mindestdicke ausgeführt ist.

Wie auch die erste in Figur 1 dargestellte Ausführungsform weist auch die in Figur 2 dargestellte Ausführungsform keinen Kühlkörper und keine Kappe auf, so dass die von den Bauelementen erzeugte Wärme durch die Absorptionsschicht 40, 140 hindurch sowie durch die äußere Kapselung 50, 150 hindurch nach außen dringt. Ein Teil der Wärme wird über das Substrat zu einem in den Figuren 1 und 2 dargestellten unteren Teil der äußeren Kapselung übertragen, der wiederum die Wärme nach außen abgibt.

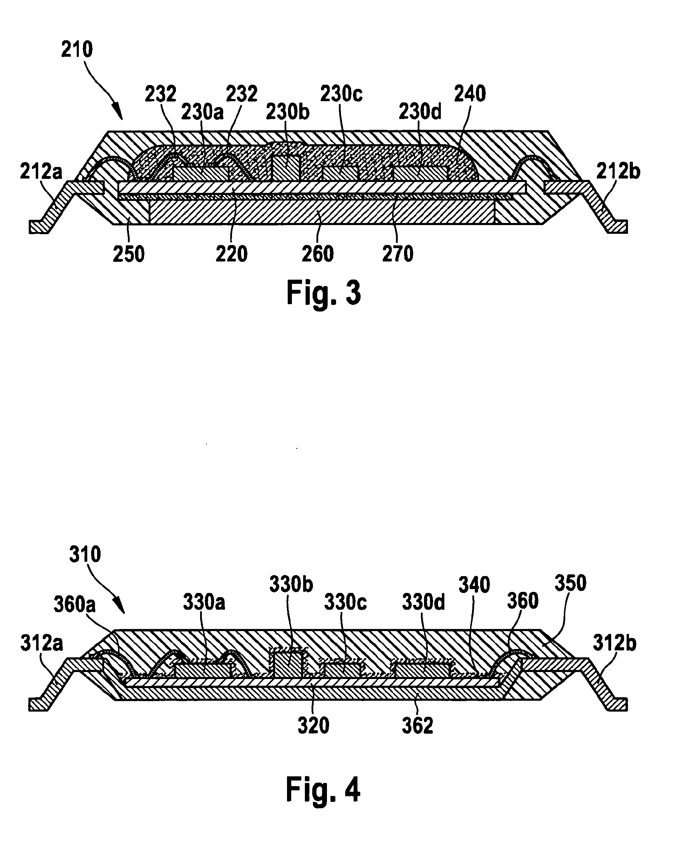

In der Figur 3 ist eine dritte Ausführungsform der erfindungsgemäßen Schaltungsvorrichtung 210 dargestellt, die einen Kühlkörper 260 in Form einer Metallplatte (beispielsweise aus Stahl, Kupfer oder Aluminium) umfasst. Wie auch die Ausführungsformen der Figuren 1 und 2 umfasst die in Figur 3 dargestellte dritte Ausführungsform ein Substrat 220, das mit Bauelementen 230a-d bestückt ist. Die Bauelemente sind über eine Löttechnik sowie über Bondingverbindungen 232 mit dem Substrat verbunden. Wie auch in der ersten Ausführungsform, die in der Figur 1 dargestellt ist, umfasst die in Figur 3 dargestellte Schaltungsvorrichtung 210 eine Absorptionsschicht 240, die lediglich einen Substratoberflächenabschnitt der Bauelementseite des Substrats (und nicht das gesamte Substrat) überdeckt. Es verbleibt ein Rand, an dem ein elektrischer Kontakt 212b mit dem Substrat verbunden ist, wobei ein weiterer Kontakt 212a mit dem Substrat über eine Kontaktstelle verbunden ist, die von der Absorptionsschicht überdeckt wird. Die Verbindung der elektrischen Kontakte mit dem Substrat, die an dem Substrat vorgesehen sind, können von der Absorptionsschicht vollständig überdeckt sein, können von der Absorptionsschicht nicht überdeckt sein oder können von der Absorptionsschicht mit einer Dicke überdeckt sein, die geringer als die Mindestdicke der Absorptionsschicht ist.

Im Vergleich zu den Figuren 1 und 2 umfasst die in Figur 3 dargestellte Schaltungsvorrichtung 210 einen Kühlkörper 260, der über eine Klebung 270 mit der Unterseite des Substrats verbunden ist, wobei die Unterseite der Bauelementseite des Substrats entgegengesetzt ist. Die äußere Kapselung umgreift die Absorptionsschicht 240 sowie die darin vorgesehenen Bauelemente 230a-d vollständig, sowie auch den Innenabschnitt der elektrischen Kontakte 212a, schließt sich jedoch nur direkt an den Kühlkörper 260 an, ohne diesen weitergehend zu überdecken, wobei eine Außenseite des Kühlkörpers, die dem Substrat abgewandt ist, nicht von der äußeren Kapselung bedeckt ist. Dies ermöglicht eine direkte Wärmeableitung der von den Bauelementen 230a-d erzeugten Wärme durch das Substrat 220 hindurch, durch die Klebung 270 zu dem Kühlkörper 260, dessen Außenseite die Wärme nach außen abgibt. Auf der Unterseite der Schaltungsvorrichtung fluchtet die äußere Kapselung 250 mit der Außenfläche des Kühlkörper 260. Es ist zu erkennen, dass der Kühlkörper 260 hier nicht die gesamte Unterseite des Substrats 220 überdeckt, sondern nur die Fläche, der auf der Bauelementseite Bauelemente gegenüberstehen. In bevorzugten Ausführungsformen ist ein Kühlelement 260 an der Unterseite der Schaltungsvorrichtung nur dort vorgesehen, wo auf der gegenüberliegenden Seite des Substrats Leistungsbauelemente vorgesehen sind, die in wesentlichem Maße Wärme erzeugen, die abgeführt werden muss.

Während die dargestellte Ausführungsform eine Kühlelement kleiner als das Substrat aufweist, beispielsweise um äußere Fertigungsvorgaben zu erfüllen, ist es bevorzugt, das Substrat (d.h. dessen Unterseite) vollständig mit dem Kühlelement abzudecken (nicht dargestellt). Das Kühlelement ist vorzugsweise so groß wie oder größer als das Substrat, um eine optimale Wärmeabfuhr zu ermöglichen. In dieser nicht dargestellten bevorzugten Ausführungsform umgreift das Kühlelement die Unterseite des Substrats vollständig.

Die Figur 4 zeigt eine vierte Ausführungsform der erfindungsgemäßen Schaltungsvorrichtung 310 mit einem Substrat 320, auf dem Bauelemente 330a-d montiert sind. Die in Figur 4 dargestellte Ausführungsform entspricht in zahlreichen Details der Ausführungsform von Figur 2. Ein wesentlicher Unterschied besteht darin, dass in Figur 4 ein Stanzgitter (das die elektrischen Kontakte vorsieht, nachdem diese von einem Stanzrahmen des Stanzgitterteils abgetrennt wurden) einen Kühlkörper auf der Unterseite der Schaltungsvorrichtung bildet. Somit können Kontakte und Kühlkörper durch ein zu stanzendes Stanzgitterteils vorgesehen werden. Die in Figur 4 dargestellte Schaltungsvorrichtung 310 umfasst ferner eine Absorptionsschicht, deren Lage 340 mit gepunkteter Linie dargestellt ist. Die Absorptionsschicht 340 ist auf der gesamten Bauelementseite des Substrats aufgebracht und überdeckt die dort vorgesehene Substratoberfläche sowie die dort vorgesehenen Bauelemente 330a-d. Ferner sind Teile der Seitenkanten des Substrats überdeckt, wobei diese Anordnung optional ist. Die Unterseite des Substrats, die der Bauelementseite entgegengesetzt ist, ist unmittelbar mit einem Kühlkörper aus geprägtem Stanzgitter 362 verbunden. Der Kühlkörper bildet vor dem Stanzen mit den Kontakten 312 ein gemeinsames Stanzgitter, wobei durch das Stanzen diese Komponenten voneinander getrennt werden. Kontakte, die mit dem Stanzgitter verbunden sind, sind zusammen mit dem Stanzgitter durchgängig als ein Metallblech ausgeführt. Die in Figur 4 (und den anderen Figuren) dargestellte unterschiedliche Schraffur der Kontakte gegenüber dem Stanzgitter stellt nicht die mechanische Verschiedenheit dieser Komponenten dar sondern stellt lediglich die unterschiedlichen Funktionen dar. Bei der Herstellung wird das bestückte oder unbestückte Substrat auf dem Kühlkörper aus geprägtem Stanzgitter 362 befestigt, bevor die äußere Kapselung 350 aufgebracht wird. Grundsätzlich kann das Substrat mit einem auf der Unterseite des Substrats vorgesehenen Kühlkörper als bestücktes oder als noch unbestücktes Substrat verbunden werden. Kühlkörper können beispielsweise mittels Wärmeleitkleber an dem Substrat befestigt werden.

Gemäß einer bevorzugten Ausführungsform sind die Kontakte 312a und 312b sowie das nach dem Stanzen verbleibende Stanzgitter 362 in Form eines Stanzteils ursprünglich einteilig ausgebildet. Alle weiteren elektrischen Kontakte sind in der Querschnittsdarstellung von Figur 4 nicht gezeigt.

In einer nicht dargestellten Ausführungsform, die der Ausführungsform von Figur 4 ähnelt, sind Kontakte in der Schaltungsvorrichtung nicht mit dem nach dem Stanzen verbleibende Stanzgitter verbunden, um so individuelle Verbindungen vorzusehen, die verschiedenes Potential haben können; durch einen Stanzrahmen vorgesehene Verbindungen vor dem Stanzen spielen nach dem Entfernen des Stanzrahmens in elektrischer Hinsicht keine Rolle mehr. Ein nicht verbundener Kontakt (ähnlich wie Kontakt 312a) ist vor dem Ende der Herstellung (d.h. vor dem Stanzen) ein Abschnitt des eines Stanzteils (d.h. einteilig mit diesem ausgebildet), ist jedoch nicht unmittelbar, sondern über einen Stanzrahmen mit dem später nach dem Stanzen verbleibenden Stanzgitter (bsp. Stanzgitter 362) verbunden. Durch den Stanzvorgang, der nach dem Aufbringen der Schicht (Schichten) ausgeführt wird, wird der Stanzrahmen entfernt, und die mittelbare Verbindung zwischen Kontakt und verbleibendes Stanzgitter wird aufgelöst. Die aufgebrachten Schichten und Kapselungen gewährleisten die mechanische (und nicht elektrisch leitende) Verbindung zwischen Kontakt und verbleibendem Stanzgitter. Vorzugsweise bilden alle Kontakte und das später nach dem Stanzen verbleibende Stanzgitter ein Stanzteil, das einen Rahmen umfasst, an dem alle Kontakte angeordnet sind, wobei durch das Stanzen der Rahmen entfernt wird und nur diejenigen Kontakte unmittelbar mit dem nach dem Stanzen verbleibenden Stanzgitter direkt verbunden bleiben, die auch vor dem Stanzen unmittelbar und nicht nur über den Rahmen mit diesem verbunden waren.

Der Kühlkörper aus geprägtem Stanzgitter wird an der Unterseite nicht von der äußeren Kapselung 350 überdeckt. Die Seitenwände des Kühlkörpers aus geprägtem Stanzgitter sind zum Substrat hin gewölbt und mit der äußeren Kapselung 350 überdeckt. Der Kühlkörper aus geprägtem Stanzgitter ist mechanisch mit dem elektrischen Kontakt 312b verbunden, so dass die äußere Kapselung 350 vorzugsweise nach dem Verbinden der elektrischen Kontakte 312a,b mit dem Kühlkörper 362 aus Stanzgitter hergestellt wird. Die Verbindung zwischen elektrischem Kontakt 312a und 312b und dem aus geprägtem Stanzgitter vorgesehenen Kühlkörper 362 kann beliebig vorgesehen sein. Die Verbindung ist vorzugsweise eine galvanische, elektrische Verbindung, die nach dem Stanzen von einem Stanzgitterteil verbleibt. Die nach dem Stanzen verbleibenden Komponenten bilden sowohl den Kühlkörper 362 als auch den elektrischen Kontakt 312b. Kühlkörper und elektrischen Kontakt 312b sind somit einteilig ausgebildet.

Die zusätzliche elektrische Verbindung 360 oder 360a zwischen elektrischem Kontakt 312a,b und Substrat (d.h. die beiden äußeren Bonds direkt am Kontakt 312 a,b) ist optional. Die Verbindung zwischen Substrat und Kühlkörper 362 wird über eine Klebeverbindung vorgesehen, wie auch der Kühlkörper in der Figur 3 mit dem Substrat über eine Klebeverbindung verbunden ist. Derartige Klebeverbindungen sehen eine weitere mechanische Entlastung vor, wie sie auch die Absorptionsschicht ermöglicht.

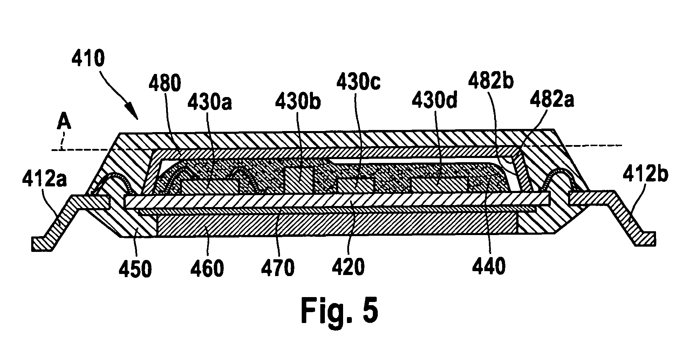

In der Figur 5 ist eine fünfte Ausführungsform der erfindungsgemäßen Schaltungsvorrichtung 410 dargestellt, die sowohl einen unteren Kühlkörper 460, der über eine Klebung 470 mit der Unterseite des Substrats 420 verbunden ist, als auch eine Kappe 480 umfasst. Der untere Kühlkörper 460 und die Kappe 480 sind zu beiden Seiten des Substrats 420 angeordnet, wobei die Kappe auf der Bauelementseite des Substrats 420 angeordnet ist. Auf der Bauelementseite trägt das Substrat die Bauelemente 430a-d, welche vollständig von der Absorptionsschicht 440 umgeben sind. Zudem sind die dort vorgesehenen Substratoberflächenabschnitte des Substrats 420 mit der Absorptionsschicht 440 überdeckt. Die zum Substrat 420 hin ausgerichteten Enden der Kappe 480 sind unmittelbar mit der Bauelementseite des Substrats 420 verbunden. Außerhalb dieser Kontaktpunkte zwischen Kappe 430 und Substrat 420 ist auf der Bauelementseite des Substrats ein Rand vorgesehen, an dem das Substrat mit elektrischen Kontakten 412a,b verbunden ist. Wie auch in den anderen Ausführungsformen wird hierzu eine Bondingverbindung verwendet, deren Kontaktpunkt außerhalb des Substratoberflächenabschnitts angeordnet ist, an dem sich die Bauelemente befinden, und der außerhalb der Kappe liegt. Die Absorptionsschicht ist vollständig innerhalb der Kappe 480 vorgesehen und ist in unmittelbarem Kontakt mit einem Teil einer Innenfläche der Kappe, sowie mit allen verbleibenden Oberflächen der Bauelemente 430a-d. Ferner besteht ein Abschnitt bzw. Abschnitte 482a,b der Innenseite der Kappe 480, der bzw. die über einen Spalt, beispielsweise einen Luftspalt von der Absorptionsschicht 440 getrennt sind. Dieser Spalt wird vorzugsweise entfernt, indem das Absorptionsmaterial in die Kappe vollständig eingefüllt wird. Hierzu weist die Kappe vorzugsweise Öffnungen auf, um Luft entweichen zu lassen, wodurch das Absorptionsmaterial die Kappe vollständig (und spaltfrei) ausfüllen kann. Werden Kappen ohne Öffnungen verwendet (wodurch ggf. Kosten eingespart werden können), dann ergibt sich ein Spalt wie dargestellt, der (abhängig von der Anwendung) keine substantiellen Nachteile für die Funktion der Schaltung erzeugt. Aus der Figur 5 ist zu erkennen, dass insbesondere ein Hochleistungsbauelement 430a über die Absorptionsschicht in unmittelbaren Wärme übertragenden Kontakt mit der Kappe 480 steht, die wiederum unmittelbar an die äußere Kapselung angrenzt, wodurch die Wärme nach außen abgeführt werden kann. Die Kappe ist in der in Figur 5 dargestellten Ausführungsform vollständig von der äußeren Kapselung 450 überdeckt, insbesondere an der Außenseite der Kappe 480, die dem Substrat abgewandt ist. Dadurch ergibt sich zwar ein mechanischer Schutz der Kappe durch die dort vorgesehene Kapselung, jedoch ist dies mit Einschränkungen hinsichtlich der Wärmeübertragung verbunden. Ist ein Spalt beispielsweise über Substratabschnitten mit Bauelementen geringer Leistung oder ohne Bauelemente angeordnet, dann führt dies nicht zu Nachteilen für die Funktion der Schaltung. Wie auch in der in Fig. 4 dargestellten Ausführungsform kann der untere Kühlkörper 460 auch Teil eines Stanzgitters sein, mit dem auch die Kontakte 412 a,b vorgesehen werden. Durch das Stanzen können Kühlkörper und Kontakte (miteinander durch ein einziges Stanzgitter verbunden) getrennt werden.

In einer weiteren, nicht dargestellten Ausführungsform reicht die äußere Kapselung ausgehend vom Substrat nur bis zu der Außenseite der Kappe , die dem Substrat abgewandt ist. In der Figur 5 ist diese Ebene A, bis zu der sich die äußere Kapselung erstreckt, und in der die Außenseite der Kappe verläuft, die dem Substrat abgewandt ist, mit einer gestrichelten Linie dargestellt. Dadurch ist diese Außenseite der Kappe nicht mit der äußeren Kapselung bedeckt, sondern stößt unmittelbar an die Umgebung der Schaltungsvorrichtung, um so einen unmittelbaren Wärmeaustausch zu ermöglichen. Die Seitenwände dieser Kappe sind jedoch mit der äußeren Kapselung überdeckt, um so die Kappe in der Schaltungsvorrichtung insbesondere mit dem Substrat und den elektrischen Kontakten stabil mechanisch zu verbinden. Die so beschriebene Ausführungsform umfasst zwei Kühlkörperelemente, d.h. eine untere Kühlkörperplatte und eine Kappe, deren Außenseiten nicht von der Kapselung überdeckt sind. Die Kühlkörper sind vorzugsweise aus Metall ausgebildet oder umfassen Metall zur besseren Wärmeübertragung. Als Metall kann beispielsweise Kupfer, Aluminium oder auch Stahl verwendet werden. Vorzugsweise werden zunächst die Kühlkörperelemente aufgebracht, d.h. durch Klebung oder mittels einer anderen Befestigungsart, um daraufhin mit der äußeren Kapselung dadurch überdeckt zu werden, dass die Kühlkörper und Teile des Substrats mit Masse der äußeren Kapselung umspritzt werden.

Gemäß dem erfindungsgemäßen Herstellungsverfahren ist das Kühlelement (in Form eines Stanzgitters) ein Träger für das Substrat. Das Kühlelement wird mit elektrisch isolierendem Wärmeleitkleber bedruckt, der Wärmeleitkleber kann auch auf andere Weise aufgebracht werden. Das als Kühlkörper arbeitende Kühlelement unterhalb des Substrats ist größer als die Fläche, über die Wärmeleitkleber aufgebracht wird. Das als unterer Kühlkörper arbeitende Kühlelement ist Bestandteil des Stanzgitters. In den Wärmeleitkleber wird das Substrat (bsp. ein LTCC Substrat) platziert. Das Substrat ist vor dem Platzieren bereits mit Bauelementen, Bonds (Innenbondung) und Kühlkörperkappe bestückt. Das Substrat wird durch den Wärmeleitkleber auch verklebt. Die Fläche, über die Wärmeleitkleber aufgebracht wird, ist größer als Substrat. Das Substrat ist vollständig in der Wärmeleitkleberfläche angeordnet. Die Kühlkörperkappe ist kleiner als das Substrat (um Außenbondungen aufnehmen zu können). Daraufhin wird Gel wird in Kappe durch eine Bohrung in der Kappe eingefüllt. In dem Substrat ist eine isolierte Leitbahnführung in mehreren Lagen möglich. Daraufhin werden die Außenbondungen angebracht. Schließlich wird Moldmasse (Epoxid) zur Bildung einer starren äußeren Kapselung im Rahmen eines Gießprozesses (Ummoldung) verwendet, um die Schaltungsvorrichtung vorzugsweise vollständig zu überdecken. Diese Herstellungsweise eignet sich für alle erfindungsgemäßen Schaltungsvorrichtungen mit Kühlelement an der Unterseite des Substrats, insbesondere für die Ausführungsformen der Figuren 3 - 5.

In einem alternativen erfindungsgemäßen Herstellungsverfahren ist das Kühlelement nicht Bestandteil des Stanzgitters. In diesem Fall wird das Kühlelement beispielsweise als Platte vorgesehen, auf der das (bestückte) Substrat befestigt wird. In diesem alternativen erfindungsgemäßen Herstellungsverfahren werden ansonsten die gleichen Schritte verwendet wie in dem Herstellungsverfahren, das im vorangehenden Absatz beschrieben ist. Die alternative Herstellungsweise eignet sich für alle erfindungsgemäßen Schaltungsvorrichtungen mit Kühlelement an der Unterseite des Substrats, insbesondere für die Ausführungsformen der Figuren 3 - 5.

## Patentansprüche

1. Gekapselte Schaltungsvorrichtung mit einem Substrat (20) sowie mehreren auf einem Substratoberflächenabschnitt einer Bauelementseite des Substrats angeordneten Bauelementen (30); einer Kapselung; zumindest einem elektrischen Kontakt (12a,b) mit einem aus der Kapselung heraus ragendem Außenabschnitt und einem in der Schaltungsvorrichtung vorgesehenen Innenabschnitt, der mit dem Substrat (20) elektrisch verbunden ist, wobei die Kapselung eine starre äußere Kapselung (50), die das Substrat (20), die Bauelemente (30) und den Innenabschnitt des zumindest einen elektrischen Kontakts (12a,b) vollständig umgreift, sowie eine komprimierbare Absorptionsschicht (40) umfasst, die zwischen den Bauelementen (30) und der äußeren Kapselung (50) vorgesehen ist und zumindest den Substratoberflächenabschnitt nahezu vollständig oder vollständig abdeckt, auf der die Bauelemente (30) angeordnet sind, und die Absorptionsschicht (50) eingerichtet ist, zumindest 90 % der der Volumenänderung entsprechende Verformung aufzunehmen, die sich durch thermisch bedingte Bewegung der Substratoberfläche und der Bauelemente (30) relativ zu der äußeren Kapselung (50) ergibt und wobei die komprimierbare Absorptionsschicht (40) einen Elastizitätsmodul aufweist, welcher kleiner als 1/10 des Elastizitätsmoduls der starren äußeren Kapselung (50) ist.

2. Schaltungsvorrichtung nach Anspruch 1, wobei die komprimierbare Absorptionsschicht (40) die gesamte Substratoberfläche der Bauelementseite abdeckt, die komprimierbare Absorptionsschicht (40) die gesamte Substratoberfläche der Bauelementseite bis auf einen äußeren Rand der Substratoberfläche der Bauelementseite, an dem zumindest eine Verbindung des zumindest einen elektrischen Kontakts mit dem Substrat (20) vorgesehen ist, die komprimierbare Absorptionsschicht (40) die Bauelemente (30) sowie die gesamte Substratoberfläche abdeckt, die die Bauelementseite, die entgegengesetzte Unterseite der Substratoberfläche sowie alle Seitenflächen des Substrats (20) umfasst, oder die komprimierbare Absorptionsschicht (40) die Bauelemente (30) sowie die Substratoberfläche abdeckt, die die Bauelementseite, alle Seitenflächen des Substrats und von der Unterseite auch die Flächen umfasst, die von einem an der Unterseite angebrachten Kühlkörper (260) abgedeckt sind.

3. Schaltungsvorrichtung nach Anspruch 1 oder 2, wobei die komprimierbare Absorptionsschicht (40) an jeder Stelle eine Dicke aufweist, die ≥ 50 µm, ≥ 200 µm, ≥ 500 µm, ≥ 1 mm, ≥ 1,5 mm, ≥ 2 mm, ≥ 2,5 mm, oder ≥ 3 mm ist, und die ≤ 5 mm, ≤ 4 mm oder ≤ 3 mm ist, und der Elastizitätsmodul der komprimierbaren Absorptionsschicht (40) kleiner als 1/100, 1/500, 1/1000, 1/5000 oder 1/10000 des Elastizitätsmoduls der starren äußeren Kapselung (50) ist.

4. Schaltungsvorrichtung nach einem der vorangehenden Ansprüche, wobei die komprimierbare Absorptionsschicht (40) aus einem Silikonmaterial, aus einem elektrisch isolierenden Gel, aus einem Silikongel, aus einem weichen Kunststoffmaterial, einem Kunstharz, oder einer Mischung hiervon vorgesehen ist.

5. Schaltungsvorrichtung nach einem der vorangehenden Ansprüche, wobei die Absorptionsschicht (440) nur auf der Bauelementseite angeordnet ist und die Schaltungsvorrichtung ferner eine Kappe (480) umfasst, die zusammen mit der Bauelementseite des Substrats einen Teil der Absorptionsschicht (440) oder die gesamte Absorptionsschicht (440) einschließt und die eine Innenfläche aufweist, welche mit einer Oberfläche der Absorptionsschicht (440), die dem Substrat (420) entgegengesetzt ist, teilweise oder vollständig in unmittelbarem körperlichen Kontakt ist.

6. Verfahren zur Herstellung einer gekapselte Schaltungsvorrichtung, mit einem Substrat (20), mehreren Bauelementen (30), zumindest einem elektrischen Kontakt (12a,b) und einer Kapselung, wobei das Verfahren die Schritte umfasst:
Bestücken eines Substratoberflächenabschnitts einer Bauelementseite des Substrats mit den Bauelementen (30);
Anbringen eines Innenabschnitts des zumindest einen elektrischen Kontakts an dem Substrat (20) zur elektrischen Verbindung des Kontakts mit dem Substrat (20); und
Umschließen des Substrats (20) mit der Kapselung; wobei das Umschließen umfasst: Aufbringen einer komprimierbaren Absorptionsschicht (40) auf die Bauelemente (30) und auf zumindest einen Substratoberflächenabschnitt, auf der die Bauelemente (30) angeordnet sind, wodurch die Bauelemente (30) und zumindest der Substratoberflächenabschnitt von der komprimierbaren Absorptionsschicht (40) vollständig bedeckt sind, und
Aufbringen einer starren äußeren Kapselung (50) auf die gesamte aufgebrachte komprimierbare Absorptionsschicht (40) und auf das gesamte Substrat (20), wodurch der Innenabschnitt des zumindest einen elektrischen Kontakts (12a,b) vollständig von der Kapselung umgeben wird und ein aus der Kapselung heraus ragender Außenabschnitt des elektrischen Kontakts (12a,b) beim Aufbringen ausgespart wird, wodurch dieser nicht von der Kapselung umgeben wird; wobei das Aufbringen der komprimierbaren Absorptionsschicht (40) mit einem komprimierbaren Material ausgeführt wird, so dass die Absorptionsschicht (40) eingerichtet ist, zumindest 90 % der der Volumenänderung entsprechende Verformung aufzunehmen, die sich durch thermisch bedingte Bewegung der Substratoberfläche und der Bauelemente (30) relativ zu der äußeren Kapselung (50) ergibt und
wobei die komprimierbare Absorptionsschicht (40) einen Elastizitätsmodul aufweist, welcher kleiner als 1/10 des Elastizitätsmoduls der starren äußeren Kapselung (50) ist.

7. Verfahren nach Anspruch 6, wobei das Aufbringen der komprimierbaren Absorptionsschicht (40) umfasst: Abdecken der gesamten Substratoberfläche der Bauelementseite mit der komprimierbaren Absorptionsschicht (40);
Abdecken der gesamten Substratoberfläche der Bauelementseite, bis auf einen äußeren Rand der Substratoberfläche der Bauelementseite, der zur Verbindung des zumindest einen elektrischen Kontakts (12a,b) mit dem Substrat (20) vorgesehen ist, mit der komprimierbaren Absorptionsschicht (40);
Abdecken der Bauelemente (30) sowie der gesamten Substratoberfläche, die die Bauelementseite, die entgegengesetzte Unterseite der Substratoberfläche sowie alle Seitenflächen des Substrats umfasst, mit der komprimierbaren Absorptionsschicht (40); oder
Abdecken der Bauelemente (30) sowie der Substratoberfläche, die die Bauelementseite, alle Seitenflächen des Substrats und von der Unterseite auch diejenigen Flächen umfasst, die von einem an der Unterseite angebrachten oder anzubringenden Kühlkörper abgedeckt sind.

8. Verfahren nach Anspruch 6 oder 7, wobei die komprimierbare Absorptionsschicht (40) aufbracht wird, mit einer Dicke an jeder Stelle der komprimierbaren Absorptionsschicht (40), die ≥ 50 µm, ≥ 200 µm, ≥ 500 µm, ≥ 1 mm, ≥ 1,5 mm, ≥ 2 mm, ≥ 2,5 mm, oder ≥ 3 mm ist, und die ≤ 5 mm, ≤ 4 mm, oder ≤ 3 mm ist, und das Material der komprimierbaren Absorptionsschicht (40) derart vorgesehen ist, dass das Elastizitätsmodul der durch den Schritt des Aufbringens vorgesehenen komprimierbaren Absorptionsschicht (40) kleiner als 1/100, 1/500, 1/1000, 1/5000 oder 1/10000 des Elastizitätsmoduls des Materials der starren äußeren Kapselung (50) ist.

9. Verfahren nach einem der Ansprüche 6 - 8, wobei das Aufbringen der Absorptionsschicht (40) ausgeführt wird durch Eintauchen in flüssiges oder fließfähiges Absorptionsschichtmaterial, Aufsprühen von flüssigem oder fließfähigem Absorptionsschichtmaterial oder Aufgießen oder Aufstempeln von flüssigem oder fließfähigem Absorptionsschichtmaterial und Härten des Absorptionsschichtmaterials zur Ausbildung der Absorptionsschicht durch Erkalten, Vernetzen des Absorptionsschichtmaterials oder UV-Härten oder Wärmehärten des Materials oder eines Teils des Materials.

10. Verfahren nach einem der Ansprüche 6 - 9, wobei die Absorptionsschicht (440) nur auf der Bauelementseite aufgebracht wird und ferner eine Kappe (480) auf die Absorptionsschicht (440) derart aufgebracht wird, dass diese zusammen mit der Bauelementseite des Substrats die gesamte Absorptionsschicht (440) einschließt und teilweise oder vollständig einen unmittelbaren Kontakt zwischen einer Innenfläche der Kappe (480) und einer Oberfläche der Absorptionsschicht (440), die dem Substrat (420) entgegengesetzt ist, herstellt, wobei die Kappe (480) vor dem Aufbringen einer starren äußeren Kapselung (450) und vor oder nach dem Aufbringen der Absorptionsschicht (440) während des Schritts des Umschließens aufgebracht wird.

## Claims

1. Encapsulated circuit device with a substrate (20) and a plurality of components (30) arranged on a substrate surface portion of a component side of the substrate; an encapsulation; at least one electrical contact (12a, b) with an outer portion, which projects from the encapsulation, and an inner portion, which is provided in the circuit device and is electrically connected to the substrate (20), wherein the encapsulation comprises a rigid outer encapsulation (50), which completely reaches around the substrate (20), the components (30) and the inner portion of the at least one electrical contact (12a, b), and also a compressible absorption layer (40), which is provided between the components (30) and the outer encapsulation (50) and almost completely or completely covers at least the substrate surface portion on which the components (30) are arranged, and the absorption layer (50) is designed to absorb at least 90% of the deformation that arises as a result of thermally induced movement of the substrate surface and of the components (30) relative to the outer encapsulation (50) and corresponds to the change in volume, and wherein the compressible absorption layer (40) has a modulus of elasticity which is less than 1/10 of the modulus of elasticity of the rigid outer encapsulation (50).

2. Circuit device according to Claim 1, wherein the compressible absorption layer (40) covers the entire substrate surface of the component side, the compressible absorption layer (40) the entire substrate surface of the component side apart from an outer periphery of the substrate surface of the component side at which at least one connection of the at least one electrical contact to the substrate (20) is provided, the compressible absorption layer (40) covers the components (30) and the entire substrate surface that comprises the component side, the opposite underside of the substrate surface and all of the side faces of the substrate (20), or the compressible absorption layer (40) covers the components (30) and the substrate surface that comprises the component side, all of the side faces of the substrate and, of the underside, also the areas that are covered by a heat sink (260) attached to the underside.

3. Circuit device according to Claim 1 or 2, wherein the compressible absorption layer (40) has at every location a thickness that is ≥ 50 µm, ≥ 200 µm, ≥ 500 µm, ≥ 1 mm, ≥ 1.5 mm, ≥ 2 mm, ≥ 2.5 mm, or ≥ 3 mm, and which is ≤ 5 mm, ≤ 4 mm or ≤ 3 mm, and the modulus of elasticity of the compressible absorption layer (40) is less than 1/100, 1/500, 1/1000, 1/5000 or 1/10000 of the modulus of elasticity of the rigid outer encapsulation (50).

4. Circuit device according to one of the preceding claims, wherein the compressible absorption layer (40) is provided from a silicone material, from an electrically insulating gel, from a silicone gel, from a soft plastics material, a synthetic resin, or a mixture thereof.

5. Circuit device according to one of the preceding claims, wherein the absorption layer (440) is only arranged on the component side and the circuit device also comprises a cap (480), which together with the component side of the substrate encloses part of the absorption layer (440) or the entire absorption layer (440) and has an inner surface which is partially or completely in direct physical contact with a surface of the absorption layer (440) that is opposite from the substrate (420).

6. Method for producing an encapsulated circuit device, with a substrate (20), a plurality of components (30), at least one electrical contact (12a, b) and an encapsulation, wherein the method comprises the steps of:
providing the components (30) on a substrate surface portion of a component side of the substrate;
attaching an inner portion of the at least one electrical contact to the substrate (20) for electrically connecting the contact to the substrate (20); and
enclosing the substrate (20) with the encapsulation; wherein
the enclosure comprises: applying a compressible absorption layer (40) to the components (30) and to at least one substrate surface portion on which the components (30) are arranged, whereby the components (30) and at least the substrate surface portion are completely covered by the compressible absorption layer (40), and
applying a rigid outer encapsulation (50) to the entire applied compressible absorption layer (40) and to the entire substrate (20), whereby the inner portion of the at least one electrical contact (12a, b) is completely surrounded by the encapsulation and an outer portion of the electrical contact (12a, b) that projects out of the encapsulation is omitted during the application, whereby it is not surrounded by the encapsulation; wherein
the application of the compressible absorption layer (40) is carried out with a compressible material, so that the absorption layer (40) is configured to absorb at least 90% of the deformation resulting from thermally induced movement of the substrate surface and of the components (30) relative to the outer encapsulation (50) that corresponds to the change in volume and wherein the compressible absorption layer (40) has a modulus of elasticity which is less than 1/10 of the modulus of elasticity of the rigid outer encapsulation (50).

7. Method according to Claim 6, wherein the application of the compressible absorption layer (40) comprises: covering the entire substrate surface of the component side with the compressible absorption layer (40);
covering the entire substrate surface of the component side with the compressible absorption layer (40) apart from an outer periphery of the substrate surface of the component side that is provided for the connection of the at least one electrical contact (12a, b) to the substrate (20); covering the components (30) and the entire substrate surface that comprises the component side, the opposite underside of the substrate surface and all of the side faces of the substrate with the compressible absorption layer (40); or covering the components (30) and the substrate surface that comprises the component side, all of the side faces of the substrate and, of the underside, also the areas that are covered by a heat sink attached or to be attached to the underside.

8. Method according to Claim 6 or 7, wherein the compressible absorption layer (40) is applied, with a thickness at every location of the compressible absorption layer (40) that is ≥ 50 µm, ≥ 200 µm, ≥ 500 µm, ≥ 1 mm, ≥ 1.5 mm, ≥ 2 mm, ≥ 2.5 mm, or ≥ 3 mm, and which is ≤ 5 mm, ≤ 4 mm or ≤ 3 mm, and the material of the compressible absorption layer (40) is provided in such a way that the modulus of elasticity of the compressible absorption layer (40) provided by the application step is less than 1/100, 1/500, 1/1000, 1/5000 or 1/10000 of the modulus of elasticity of the material of the rigid outer encapsulation (50).

9. Method according to one of Claims 6-8, wherein the application of the absorption layer (40) is carried out by immersion in liquid or flowable absorption layer material, spraying on liquid or flowable absorption layer material or pouring or stamping on liquid or flowable absorption layer material and curing the absorption layer material to form the absorption layer by cooling, crosslinking the absorption layer material or UV curing or thermal curing of the material or of part of the material.

10. Method according to one of Claims 6-9, wherein the absorption layer (440) is only applied on the component side and furthermore a cap (480) is applied to the absorption layer (440) in such a way that together with the component side of the substrate it encloses the entire absorption layer (440) and partially or completely establishes a direct contact between an inner surface of the cap (480) and a surface of the absorption layer (440) that is opposite from the substrate (420), wherein the cap (480) is applied before the application of a rigid outer encapsulation (450) and before or after the application of the absorption layer (440) during the enclosing step.

## Revendications

1. Ensemble de circuit encapsulé, présentant un substrat (20) ainsi que plusieurs composants (30) disposés sur une partie de surface du substrat d'un côté composants du substrat,
une encapsulation,
au moins un contact électrique (12a, b) doté d'une partie extérieure qui déborde de l'encapsulation et une partie intérieure prévue dans l'ensemble du circuit et raccordé électriquement au substrat (20),
l'encapsulation comprenant une encapsulation extérieure (50) rigide qui englobe complètement le substrat (20), les composants (30) et la partie intérieure du ou des contacts électriques (12a, b) ainsi qu'une couche compressible d'absorption (40) prévue entre les composants (30) et l'encapsulation extérieure (50) et qui recouvre presque complètement ou complètement au moins la partie de surface du substrat sur laquelle les composants (30) sont disposés,
la couche d'absorption (50) étant conçue pour reprendre au moins 90 % de la déformation qui correspond à la modification de volume qui résulte du déplacement d'origine thermique de la surface du substrat et des composants (30) par rapport à l'encapsulation extérieure (50), la couche compressible d'absorption (40) présentant un module d'élasticité inférieur à 1/10 du module d'élasticité de l'encapsulation extérieure (50) rigide.

2. Ensemble de circuit selon la revendication 1, dans lequel la couche compressible d'absorption (40) recouvre la totalité de la surface de substrat du côté composants, la couche compressible d'absorption (40) la totalité de la surface du substrat du côté composants jusqu'au bord extérieur de la surface de substrat du côté composants, bord sur lequel est prévue au moins une liaison du ou des contacts électriques avec le substrat (20), la couche compressible d'absorption (40) recouvrant les composants (30) ainsi que la totalité de la surface du substrat qui comporte le côté composants, le côté inférieur opposé de la surface du substrat ainsi que toutes les surfaces latérales du substrat (20), ou la couche compressible d'absorption (40) recouvrant les composants (30) ainsi que la surface du substrat qui comporte le côté composants, toutes les surfaces latérales du substrat et également les surfaces du côté inférieur qui sont recouvertes par un corps de refroidissement (260) appliqué sur le côté inférieur.

3. Ensemble de circuit selon les revendications 1 ou 2, dans lequel la couche compressible d'absorption (40) présente en chaque emplacement une épaisseur ≥ 50 µm, ≥ 200 µm, ≥ 500 µm, ≥ 1 mm, ≥ 1, 5 mm, ≥ 2 mm, ≥ 2,5 mm ou ≥ 3 mm, et ≤ 5 mm, ≤ 4 mm ou ≤ 3 mm, le module d'élasticité de la couche compressible d'absorption (40) étant inférieur à 1/100, 1/500, 1/1000, 1/5000 ou 1/10 000 du module d'élasticité de l'encapsulation extérieure (50) rigide.

4. Ensemble de circuit selon l'une des revendications précédentes, dans lequel la couche compressible d'absorption (40) est constituée d'un matériau à base de silicone, d'un gel électriquement isolant, d'un gel de silicone, d'une matière synthétique molle, d'une résine synthétique ou d'un de leurs mélanges.

5. Ensemble de circuit selon l'une des revendications précédentes, dans lequel la couche d'absorption (440) est disposée uniquement sur le côté composants et l'ensemble de circuit comporte en outre un capot (480) qui englobe avec le côté composants du substrat une partie de la couche d'absorption (440) ou la totalité de la couche d'absorption (440) et qui présente une surface intérieure en contact matériel direct, partiel ou complet, avec une surface de la couche d'absorption (440) opposée au substrat (420).

6. Procédé de fabrication d'un ensemble de circuit encapsulé présentant un substrat (20), plusieurs composants (30), au moins un contact électrique (12a, b) et une encapsulation,
le procédé comportant les étapes qui consistent à :
équiper de composants (30) une partie de la surface du substrat côté composants,
placer une partie intérieure du ou des contacts électriques sur le substrat (20) pour assurer la liaison électrique du contact avec le substrat (20) et
englober le substrat (20) par l'encapsulation,
l'englobement comportant l'application d'une couche compressible d'absorption (40) sur les composants (30) et sur au moins une partie de surface du substrat sur laquelle les composants (30) sont disposés, grâce à quoi les composants (30) et au moins la partie de la surface du substrat sont complètement recouverts par la couche compressible d'absorption (40), et
appliquer une encapsulation extérieure (50) rigide sur la totalité de la couche compressible d'absorption (40) qui a été appliquée et sur la totalité du substrat (20), grâce à quoi la partie intérieure du ou des contacts électriques (12a, b) est entourée complètement par l'encapsulation et une partie extérieure du contact électrique (12a, b) qui déborde hors de l'encapsulation est réservée lors de l'application de telle sorte qu'elle ne soit pas englobée dans l'encapsulation,
l'application de la couche compressible d'absorption (40) étant réalisée avec un matériau compressible de telle sorte que la couche d'absorption (40) soit en mesure de reprendre au moins 90 % de la déformation qui correspond à la modification de volume qui résulte du déplacement d'origine thermique de la surface du substrat et des composants (30) par rapport à l'encapsulation extérieure (50), la couche compressible d'absorption (40) présentant un module d'élasticité inférieur à 1/10 du module d'élasticité de l'encapsulation extérieure (50) rigide.

7. Procédé selon la revendication 6, dans lequel l'application de la couche compressible d'absorption (40) comprend
le recouvrement de la totalité de la surface du substrat côté composants par la couche compressible d'absorption (40),
le recouvrement par la couche compressible d'absorption (40) de la totalité de la surface de substrat côté composants jusqu'au bord extérieur de la surface du substrat côté composants qui est prévu pour relier le ou les contacts électriques (12a, b) avec le substrat (20),
le recouvrement par la couche compressible d'absorption (40) des composants (30) ainsi que de la totalité de la surface du substrat qui comporte le côté composants, le côté inférieur opposé de la surface du substrat ainsi que toutes les surfaces latérales du substrat ou
le recouvrement des composants (30) ainsi que de la surface du substrat qui comporte le côté composants, toutes les surfaces latérales du substrat et également les surfaces du côté inférieur qui sont recouvertes par un corps de refroidissement appliqué sur le côté inférieur ou destiné à y être placé.

8. Procédé selon les revendications 6 ou 7, dans lequel la couche compressible d'absorption (40) est appliquée en chaque emplacement de la couche compressible d'absorption (40) à une épaisseur ≥ 50 µm, ≥ 200 µm, ≥ 500 µm, ≥ 1 mm, ≥ 1, 5 mm, ≥ 2 mm, ≥ 2, 5 mm ou ≥ 3 mm, et ≤ 5 mm, ≤ 4 mm ou ≤ 3 mm et en ce que le matériau de la couche compressible d'absorption (40) est prévu de telle sorte que le module d'élasticité de la couche compressible d'absorption (40) prévue à l'étape d'application soit inférieur à 1/100, 1/500, 1/1000, 1/5000 ou 1/10 000 du module d'élasticité de l'encapsulation extérieure (50) rigide.

9. Procédé selon l'une des revendications 6 à 8, dans lequel l'application de la couche d'absorption (40) est réalisée par immersion dans un matériau liquide ou fluide de couche d'absorption, pulvérisation d'un matériau liquide ou fluide de couche d'absorption, versage ou application au tampon d'un matériau liquide ou fluide de couche d'absorption et durcissement du matériau de couche d'absorption de manière à former la couche d'absorption par refroidissement, réticulation du matériau de la couche d'absorption ou durcissement aux UV ou durcissement thermique du matériau ou d'une partie du matériau.

10. Procédé selon l'une des revendications 6 à 9, dans lequel la couche d'absorption (440) n'est appliquée que sur le côté composants et un capot (480) est en outre appliqué sur la couche d'absorption (440) de telle sorte que ce dernier englobe avec le côté composants du substrat la totalité de la couche d'absorption (440) et établisse partiellement ou complètement un contact direct entre une surface intérieure du capot (480) et une surface de la couche d'absorption (440) opposée au substrat (420), le capot (480) étant appliqué avant l'application d'une encapsulation extérieure (450) rigide ou avant ou après l'application de la couche d'absorption (440) pendant l'étape d'englobement.
